# FASCICULE DE BREVET EUROPEEN

(11) **EP 2 951 336 B1**
(45) Date de publication et mention de la délivrance du brevet: **22.03.2017**
(21) Numéro de dépôt: 14701390.8
(22) Date de dépôt: 27.01.2014
(51) Int. Cl.: C30B 25/00, C30B 25/12, C30B 28/14, C30B 29/04, C30B 29/60, C30B 35/00, B82Y 40/00, C30B 25/10, C30B 25/18

(54) **PROCEDE DE FABRICATION D'ELEMENTS MOULES EN DIAMANT MONOCRISTALLIN OU A TRES FAIBLE DENSITE DE JOINTS DE GRAIN DE TAILLES MICRO, SUBMICRO OU NANOMETRIQUES**
VERFAHREN ZUR HERSTELLUNG VON FORMELEMENTEN AUS MONOKRISTALLINEM DIAMANT ODER DIAMANT MIT SEHR NIEDRIGER DICHTE VON KORNGRENZEN, VON MIKROMETRISCHER, SUBMIKROMETRISCHER ODER NANOMETRISCHER GRÖSSE
PROCESS FOR PRODUCING MOULDED ELEMENTS MADE OF DIAMOND WHICH IS MONOCRYSTALLINE OR HAS A VERY LOW DENSITY OF GRAIN BOUNDARIES, OF MICROMETRIC, SUBMICROMETRIC OR NANOMETRIC SIZES

(30) Priorité: 29.01.2013 FR 1350746
(43) Date de publication de la demande: 09.12.2015
(73) Titulaire: Commissariat à l'Énergie Atomique et aux Énergies Alternatives, 75015 Paris (FR)
(72) Inventeur: GIRARD, Hugues, F-78220 Viroflay (FR); SAADA, Samuel, F-92340 Bourg La Reine (FR)
(74) Mandataire: Brevalex
(86) Numéro de dépôt international: PCT/EP2014/051466
(87) Numéro de publication internationale: WO 2014/118103

(56) Documents cités:
- HUGUES A. GIRARD ET AL: "Encapsulated nanodiamonds in smart microgels toward self-assembled diamond nanoarrays", DIAMOND AND RELATED MATERIALS, vol. 33, 10 janvier 2013 (2013-01-10), pages 32-37, XP055089113, ISSN: 0925-9635, DOI: 10.1016/j.diamond.2012.12.007

## Description

### DOMAINE TECHNIQUE

La présente invention se rapporte à un procédé permettant d'obtenir des éléments en diamant monocristallin ou à très faible densité de joints de grain et ayant une taille micrométrique, submicrométrique, voire nanométrique.

Ce procédé trouve notamment application dans tous les domaines dans lesquels il est utile d'avoir une structure tridimensionnelle en diamant, en particulier pour des applications en optique, en électrochimie, en électronique ou encore en médecine (implants).

### ÉTAT DE LA TECHNIQUE ANTÉRIEURE

Le diamant est un matériau particulièrement intéressant du fait de ses nombreuses propriétés exceptionnelles, parmi lesquelles on peut citer sa biocompatibilité, ses propriétés électrochimiques, de luminescence et de conduction de la chaleur.

Le développement de ce matériau en optique, en électronique, pour la réalisation de systèmes MEMS par exemple (« Micro ElectroMechanical Systems» en anglais), ou dans tout autre domaine technique pouvant mettre à profit les propriétés intéressantes du diamant nécessite la réalisation d'éléments en diamant à trois dimensions, tels que piliers, pointes, disques, pyramides, etc... de tailles micrométriques, submicrométriques, voire nanométriques.

Des éléments à trois dimensions en diamant sont actuellement obtenus par conformation de couches minces de diamant dans un moule (et plus précisément, dans une cavité d'un moule, si le moule comporte plusieurs cavités).

La synthèse de couches mince de diamant s'effectue généralement par croissance CVD (pour « Chemical Vapor Déposition » en anglais, c'est-à-dire un dépôt chimique en phase vapeur). Une fine couche de diamant (de l'ordre de quelques dizaines de nanomètres à quelques dizaines de micromètres) est alors déposée à partir d'un plasma d'hydrogène et de méthane sur un substrat, qui peut être par exemple du silicium, du verre, une couche métallique, etc... L'initiation de la croissance CVD sur le substrat s'effectue via l'utilisation de nanoparticules de diamant, que l'on vient déposer préalablement sur la surface du substrat. Ces nanoparticules vont alors croître et former un film polycristallin de diamant, c'est-à-dire un assemblage de cristaux de diamant coalescés reliés entre eux par des joints de grain.

Les techniques de dépôt des nanoparticules de diamant et de croissance CVD sont maintenant très bien contrôlées et peuvent être effectuées sur des substrats dits « plans », mais aussi sur des substrats présentant des motifs 3D. Ainsi, la surface de substrats présentant des cavités (puits, par exemple) peut être recouverte de diamant et de tels substrats peuvent servir de moules si la couche de diamant remplit les cavités. Ces moules peuvent être réalisés en silicium ou dans d'autres matériaux, avec des cavités à l'échelle micrométrique, submicrométrique ou nanométrique, et sont dissous à la fin de la croissance pour libérer les éléments en diamant réalisés dans les motifs du moule (cf. document **[1]**). Cette technique utilisée pour former des éléments 3D en diamant est maintenant bien connue et est utilisée notamment pour la réalisation de MEMS et de nanopiliers en diamant (cf. document **[2]**).

Cependant, si cette technique permet la réalisation d'éléments nanométriques en diamant, le matériau généré est polycristallin, du fait de l'utilisation d'un grand nombre de nanoparticules de diamant déposées dans le moule pour initier la croissance CVD. En effet, afin de reproduire la forme du moule, toute sa surface est recouverte avant croissance de nanoparticules, le but étant d'atteindre une densité maximale (typiquement 10¹¹ particules/cm²). Le matériau qui en résulte consiste donc en un assemblage de cristallites ou grains de diamant, avec une proportion de joints de grain directement liée à la densité initiale de nanoparticules déposées. Par ailleurs, la taille de ces grains varie selon la densité de nanoparticules déposées dans les cavités du moule et les dimensions de ces cavités. Il peut donc y avoir, à la fin de la croissance CVD, un gradient de taille de grains au sein d'un même élément.

Ici réside la principale limitation de cette technique pour la réalisation d'éléments 3D en diamant à partir de moules sacrificiels. En effet, dans certains cas, l'aspect polycristallin, les joints de grain et le gradient de taille de grains rencontré dans ce type de matériau est incompatible avec l'exploitation de tels éléments dans différents domaines comme en optique, en électronique ou en dissipation thermique. La présence de joints de grains induit des défauts dans le matériau et la non-continuité du matériau du fait de sa nature polycristalline inhibe ou diminue fortement certaines propriétés du diamant, comme sa conduction thermique, ses propriétés de transport ou ses propriétés optiques (indice de réfraction inhomogène et phénomènes de diffusion, par exemple).

Des éléments à trois dimensions en diamant peuvent également être obtenus par gravure de couches minces en diamant. Cette méthode, plus compliquée à mettre en oeuvre que la méthode décrite ci-dessus, présente l'avantage de permettre la réalisation d'éléments en diamant monocristallin. Pour ce faire, on procède à la croissance d'un film épais monocristallin (par procédé CVD par exemple), puis à sa structuration par gravure sélective. Cette approche est dite « top-down » et nécessite l'utilisation de masques de gravure (déposés par lithographie optique ou électronique) et l'emploi de techniques de gravure spécifiques. Par cette méthode, des éléments de très bonne qualité cristalline peuvent être obtenus. A titre d'exemple, Babinec et al. ont exploité cette approche pour réaliser des nanopiliers en diamant monocristallin (0,2 x 2 µm) de qualité cristalline exceptionnelle, dans lesquels des centres luminescents ont été incorporés pour la génération et l'extraction de photons uniques (cf. document **[3]**). Après dépôt d'un masque de gravure par lithographie électronique, un échantillon épais de diamant monocristallin est exposé à une gravure par RIE (« Reactive Ion Etching » en anglais), libérant des piliers de très faibles dimensions.

Si la qualité cristalline des éléments générés par cette méthode correspond aux attentes, elle nécessite cependant la croissance d'un film épais en diamant, dont une grande partie sera finalement gravée, ce qui constitue une forte limitation en termes de coût et de temps.

Par ailleurs, cette technologie n'est pas transférable à grande échelle (industrielle), les couches minces de diamant monocristallin initiales étant actuellement très limitées dans leurs dimensions (de 5x5 mm, au maximum).

De plus, les techniques de gravure et de lithographie nécessaires à la structuration des films en diamant diffèrent de celles généralement utilisées dans l'industrie des semi-conducteurs (silicium, par exemple), ce qui limite d'autant leur développement.

Au regard des inconvénients susmentionnés, les inventeurs se sont fixé pour objectif de mettre en place un nouveau procédé de fabrication qui permette d'obtenir des éléments en diamant monocristallin ou à très faible densité de joints de grain, de tailles micrométriques, submicrométriques ou nanométriques et qui puisse être mis en oeuvre industriellement.

### EXPOSÉ DE L'INVENTION

Le procédé objet de l'invention repose sur le principe selon lequel, en limitant le nombre de particules déposées dans une même cavité d'un moule, on réduit d'autant la polycristallinité du matériau final, l'objectif étant, dans le cas idéal, d'avoir une seule nanoparticule de diamant déposée au fond d'une cavité afin d'obtenir, par croissance CVD, un élément en diamant monocristallin dont la forme finale est celle de la cavité. L'enjeu pour les inventeurs était donc de pouvoir contrôler le dépôt localisé d'un nombre limité (voire égal à un, dans le cas idéal) de nanoparticules de diamant dans une cavité de dimensions micro, submicro ou nanométriques. Or, l'utilisation d'une simple suspension colloïdale de nanoparticules de diamant ne permet pas un tel résultat, du fait principalement de l'anisotropie de la suspension (forme et taille des particules), des phénomènes d'agrégation et de la taille difficilement contrôlable des nanoparticules. Même en diluant fortement la suspension de nanodiamants, la probabilité d'obtenir une seule particule au fond d'une cavité est très faible.

Ainsi, l'invention a trait à un procédé de fabrication d'éléments moulés en diamant de tailles nanométriques, submicrométriques ou micrométriques, ledit procédé comprenant les étapes suivantes :
a) la formation de billes de tailles nanométriques, submicrométriques ou micrométriques comprenant une nanoparticule en diamant enrobée par un matériau d'enrobage, par mise en contact de particules de diamant de tailles nanométriques avec un matériau d'enrobage ;
b) l'introduction d'une bille dans des cavités d'un moule sacrificiel, les cavités formant une empreinte des éléments à fabriquer ;
c) l'élimination du matériau d'enrobage ;
d) la formation des éléments en diamant dans les cavités contenant une nanoparticule, par croissance de diamant à partir des nanoparticules ;
e) libération des éléments en diamant, par élimination partielle ou totale du moule sacrificiel.

Bien évidemment, les cavités du moule ont une forme adaptée à l'obtention des éléments à fabriquer. Les cavités forment une empreinte des éléments à fabriquer et reproduisent la forme des éléments à fabriquer.

De préférence, à l'étape b), on essaie d'introduire une bille dans chaque cavité du moule sacrificiel, si c'est possible.

De préférence, les nanoparticules utilisées à l'étape a) sont en diamant monocristallin.

A l'issue de l'étape e), on obtient des éléments en diamant qui sont, de préférence, monocristallins ou qui, à tout le moins, ont une très faible densité de joints de grain. Dans le cadre de la présente invention, on considère qu'un élément de tailles nanométriques, submicrométriques ou micrométriques a une très faible densité de joints de grain lorsqu'il est formé au maximum de quatre cristallites ou cristaux (sachant que chaque nanoparticule introduite dans une cavité du moule donne naissance à un cristallite ou cristal). Les éléments obtenus par le procédé selon l'invention ont donc une qualité cristalline qui est améliorée par rapport aux éléments obtenus dans l'art antérieur par conformation d'une couche mince dans un moule. De plus, ils sont obtenus d'une manière beaucoup moins coûteuse et longue que par gravure d'une couche mince monocristalline.

Avant d'entrer plus en détail dans l'exposé de l'invention, nous précisons les définitions suivantes.

Dans le cadre de la présente invention, on entend par « nanoparticule » une particule de tailles nanométriques.

Dans ce qui précède et ce qui suit, le terme « taille », appliqué à des particules ou à des billes, désigne la plus grande dimension de ces particules ou de ces billes ; le terme « nanométrique » signifie supérieur ou égal à 1 nanomètre et inférieur ou égal à 100 nanomètres; le terme « submicrométrique » signifie supérieur à 100 nanomètres et inférieur à 1000 nanomètres; le terme « micrométrique » signifie supérieur ou égal à 1 micromètre et inférieure à 1000 micromètres.

On rappelle par ailleurs que le terme « particule » désigne un élément dont le rapport de la plus grande dimension sur la plus petite dimension est inférieur ou égal à 5.

Dans ce qui précède et ce qui suit, le terme « bille » désigne une enveloppe renfermant une nanoparticule de diamant et dont le rapport de la plus grande dimension sur la plus petite dimension est inférieur ou égal 1,2. Les billes peuvent donc avoir une forme sphérique ou quasi-sphérique.

Le principe du procédé objet de l'invention repose sur l'utilisation de nanoparticules de diamant encapsulées permettant leur localisation dans les cavités d'un moule et l'utilisation des cavités du moule pour contraindre la forme des éléments en diamant monocristallin ou de faible polycristallinité obtenus dans ces cavités par croissance CVD à partir d'une unique nanoparticule de diamant ou, au plus, de quatre nanoparticules de diamant.

L'encapsulation des nanoparticules de diamant dans un matériau d'enrobage organique adapté permet d'isoler les nanoparticules entre elles. Elle permet également d'unifier la forme des éléments (billes) en suspension dans une solution, de contrôler finement leur taille pour l'adapter à celle des cavités du moule et de leur conférer des propriétés colloïdales améliorées (répulsion stériques et/ou électrostatiques). Ainsi, à la différence de nanoparticules de diamant classiques dont la taille en solution peut être inhomogène (agrégation, distribution en taille des particules) et dont les propriétés colloïdales sont médiocres, des particules encapsulées présentent les propriétés colloïdales de sphères « parfaites ». La synthèse chimique de ces billes permet de contrôler très finement leur distribution en taille et donne des suspensions quasi-monodisperses. Les différences de diamètre souvent observées dans les solutions de nanoparticules de diamant sont ainsi très fortement lissées. De même, l'anisotropie de forme des particules de diamant (présence de facettes, défauts de surface, etc...) est aussi lissée par l'encapsulation, donnant des sphères presque parfaites. Ces deux derniers points (monodispersité et anisotropie de forme) sont essentiels pour contrôler le comportement colloïdal de particules. Enfin, l'encapsulation chimique permet d'adapter la taille des billes à la dimension des cavités du moule, afin de limiter le nombre de particules déposées dans une même cavité.

Ensuite, via un dépôt adapté de la suspension de nanoparticules encapsulées (dépôt en voie liquide, par exemple par trempage-retrait (« dip coating » en anglais) ou par dépôt à la tournette (« spin coating » en anglais)), il devient possible de déposer sélectivement les nanoparticules de diamant dans les cavités du moule et, grâce à la limitation des phénomènes d'agrégation, à la répulsion native des billes entres elles et par ajustement de la dimension des billes aux dimensions des cavités du moule, de n'avoir qu'une bille par cavité et, par la suite, la croissance par CVD de motifs en diamant monocristallin ou à très faible densité de joints de grain. De tels dépôts de sphères nanométriques dans les cavités d'un moule ont déjà été réalisés dans la littérature et ne constituent pas une limitation technologique importante.

Concernant l'étape a) du procédé selon l'invention, elle peut comprendre les opérations successives suivantes :
- la dispersion des nanoparticules dans un solvant (par exemple de l'eau) ;
- le mélange de la suspension ainsi obtenue avec un ou plusieurs monomères, un ou plusieurs agents de réticulation du monomère et un ou plusieurs agents d'amorçage d'une réaction de réticulation du monomère, ce mélange étant réalisé sous agitation ; et
- la polymérisation et la réticulation du ou des monomères, pour obtenir la formation d'une couche de polymère réticulé autour des nanoparticules.

Concernant l'étape b), elle peut comprendre le dépôt, par voie liquide, des billes dans les cavités du moule. De préférence, l'étape b) est réalisée par trempage-retrait ou par dépôt à la tournette. Ces techniques sont bien connues de l'homme du métier et sont décrites dans la littérature (cf. document **[4]** par exemple).

Pour rappel, la technique dite de trempage-retrait consiste à immerger le moule dans la suspension contenant les billes et à le retirer de la suspension avec une vitesse contrôlée. Dans le cadre de la présente invention, si l'étape b) est réalisée par trempage-retrait, on procède de préférence à l'extraction verticale du moule de la suspension à vitesse constante et contrôlée, typiquement inférieure à 10 µm/s.

Pour la technique du dépôt à la tournette, on procède au « balayage » de la surface du moule par la suspension de particules encapsulées.

Dans ces dépôts par voie liquide, on joue sur un effet de capillarité et de taille pour faire rentrer les billes à l'intérieur des cavités du moule.

Concernant l'étape c), elle peut être une dissolution chimique ou une destruction thermique, la destruction étant de préférence réalisée avec le plasma utilisé au cours de l'étape d).

Concernant l'étape d), la croissance de diamant dans les cavités à partir des nanoparticules est réalisée par dépôt chimique en phase vapeur assisté par plasma. Le dépôt chimique en phase vapeur assisté par plasma est de préférence réalisé en utilisant un flux gazeux comprenant une source de carbone, de préférence un ou plusieurs hydrocarbures, éventuellement en mélange avec de l'hydrogène et/ou un ou plusieurs gaz neutres à une température allant de 350°C à 1000°C et à une pression allant de l'ultravide à la pression atmosphérique. Il peut par exemple s'agir d'un dépôt CVD à l'aide d'un plasma d'hydrogène et de méthane (mélange de H₂/CH₄ à 750°C). Le plasma utilisé au cours de la croissance CVD peut être créé en utilisant une source d'énergie comme des micro-ondes (dépôt MPCVD), des Radio-Fréquences (dépôt RFCVD) ou un filament chaud (dépôt HFCVD).

L'étape c) et l'étape d) peuvent être réalisées successivement ou simultanément.

Les étapes c) et d) sont mises en oeuvre successivement lorsque, par exemple, l'étape c) d'élimination du matériau d'enrobage des billes est réalisée par dissolution chimique, par exemple à l'aide d'une solution d'acide fluorhydrique.

Les étapes c) et d) sont mises en oeuvre simultanément lorsque, par exemple, l'étape c) est réalisée à l'aide du plasma utilisé pour la croissance CVD de l'étape d). On assiste alors à l'élimination in situ du matériau d'enrobage lors du plasma CVD. Cette destruction in situ est possible lorsque le matériau d'enrobage est un polymère, par exemple le pNIPAM.

Concernant l'étape e), l'élimination est de préférence une dissolution chimique. Par exemple, dans le cas d'un moule en silicium, on peut l'éliminer en utilisant un mélange d'acide fluorhydrique et d'acide nitrique. Les éléments, une fois le moule dissous, peuvent être récupérés par centrifugation ou filtration.

De préférence, les billes obtenues à l'issue de l'étape a) ont un diamètre compris entre 0,6 et 0,8 fois la plus petite dimension des cavités, par exemple le diamètre si les cavités sont des trous circulaires. De préférence, les cavités du moule ont une plus grande dimension et le rapport entre la dimension la plus petite et la dimension la plus grande est compris entre 0,3 et 1. Ce rapport garantit qu'il y aura un effet de capillarité au niveau des cavités, ce qui facilite l'introduction d'une seule bille dans chaque cavité du moule.

Le matériau d'enrobage utilisé dans le procédé objet de l'invention peut être tout matériau organique apte à enrober une nanoparticule de diamant dans une enveloppe de forme sphérique ou quasi-sphérique. De préférence, le matériau choisi présente une répulsion électrostatique en surface, de sorte que les billes une fois réalisées ont une répulsion native (répulsion stérique et électrostatique) et se repoussent les unes les autres, évitant ainsi aux billes de s'agglomérer. Il peut être choisi parmi les polymères dont le monomère est apte à s'adsorber sur une nanoparticule de diamant (par exemple par greffage covalent, interaction électrostatique, liaison hydrogène ou liaison de Van der Waals). Les monomères peuvent par exemple être du styrène (pour réaliser des billes en polystyrène), du chitosan, du méthylmétacrylate (pour réaliser du PMMA), du N-isopropylacrylamide (pour réaliser du pNIPAM), etc.

Une fois le monomère adsorbé sur la nanoparticule, le monomère peut être polymérisé. De préférence, le matériau d'enrobage est le pNIPAM.

Le matériau du moule sacrificiel doit pouvoir résister à l'exposition au plasma utilisé au cours de l'étape d) de formation des éléments en diamant; si le matériau d'enrobage des billes est éliminé par dissolution chimique à l'étape c), le matériau du moule doit également pouvoir résister au mélange utilisé pour cette dissolution chimique. Enfin, le matériau choisi doit pouvoir être dissous chimiquement. Il est également souhaitable que le matériau choisi soit facilement usinable, afin que la réalisation des cavités ne soit pas trop compliquée. Le matériau du moule sacrificiel peut être choisi parmi un métal, un alliage métallique ou un oxyde. Avantageusement, le moule est en silicium et est éliminé par dissolution chimique dans un mélange d'acide fluorhydrique et d'acide nitrique.

Un des avantages du procédé objet de l'invention est qu'il ne nécessite aucune étape technologique « lourde » en termes de moyens, mais seulement une étape de synthèse chimique pour réaliser l'encapsulation des nanoparticules de diamant (formation des billes). Cette synthèse a l'avantage de pouvoir être effectuée sur un grand volume de nanoparticules, les particules encapsulées étant par la suite parfaitement stables dans le temps.

Ainsi, le procédé objet de l'invention permet la réalisation d'éléments en diamant par une approche dite « bottom-up », en utilisant des technologies déjà éprouvées : la structuration du moule en silicium peut profiter de toutes les techniques déjà connues pour ce matériau, déjà adaptées à la grande surface, et déjà développées industriellement ; les nanodiamants sont disponibles en quantité industrielle (notamment via la filière du polissage), leur encapsulation ne nécessite que quelques étapes chimiques non limitatives, et leur dépôt peut s'effectuer par des techniques déjà employées dans les industries de haute technologie (dépôt par tournette et/ou par trempage) ; l'élimination du matériau d'enrobage des billes peut se faire soit directement *in-situ* à l'aide du plasma utilisé au cours de la croissance CVD (dans le cas, par exemple, d'un enrobage polymérique), soit au préalable par une dissolution chimique ; le moule sacrificiel peut être éliminé par dissolution chimique.

Au final, le procédé selon l'invention est beaucoup plus économique en termes de coût et de temps par rapport à l'approche par gravure décrite dans l'art antérieur. De plus, les éléments ainsi obtenus ne sont pas limités à la dimension du matériau initial avant sa gravure (généralement de quelques millimètres de côté pour une couche mince de diamant monocristallin) et le procédé objet de l'invention ne nécessite pas de mise en oeuvre d'étapes lourdes technologiquement (comme c'est le cas lors de la gravure d'une couche de diamant).

Les principaux motifs des éléments réalisables par le procédé objet de l'invention concernent la fabrication de pointes, piliers ou cônes en diamant monocristallin ou à très faible densité de joints de grain, de tailles nanométriques à micrométriques, les empreintes de ces motifs étant facilement réalisables dans un moule.

L'absence ou la forte limitation du nombre de joints de grain dans ce type de motifs les rend très intéressants pour l'optique : il y a actuellement un fort développement de dispositifs en diamant pour la réalisation de sources de photons uniques, ou de cristaux photoniques en diamant. La qualité améliorée du matériau est aussi intéressante pour la réalisation de dispositifs électrochimiques à forte surface développée (notamment pour la réalisation d'implants pour la stimulation électrique).

La présente invention concerne également un procédé de fabrication d'une structure en diamant comprenant, sur l'une de ses faces, une pluralité d'éléments de tailles nanométriques, submicrométriques ou micrométriques, ledit procédé comprenant la mise en oeuvre du procédé de fabrication d'éléments en diamant de tailles nanométriques, submicrométriques ou micrométriques tel que décrit ci-dessus, une étape étant ajoutée entre l'étape d) et l'étape e), et cette étape consistant en une croissance catalytique de diamant par dépôt chimique en phase vapeur à partir des éléments obtenus à l'étape d), jusqu'à l'obtention d'une coalescence des éléments, formant ainsi la structure.

A la différence du procédé de fabrication d'éléments de tailles nanométriques, submicrométriques ou micrométriques, où la croissance des éléments est stoppée lorsque les cavités du moule sont partiellement, et de préférence totalement, remplies, pour la réalisation de la structure, la croissance se poursuit en dehors des cavités jusqu'à ce que les éléments coalescent (réunion des éléments adjacents). Les éléments sont alors joints les uns aux autres, formant une structure qui est plus facilement manipulable que les éléments eux-mêmes.

### BRÈVE DESCRIPTION DES DESSINS

L'invention sera mieux comprise, et d'autres détails, avantages et caractéristiques de celle-ci apparaîtront à la lecture de la description suivante faite à titre d'exemple non limitatif et en référence aux dessins annexés dans lesquels :
- la figure 1 représente une vue schématique en coupe d'une bille telle qu'utilisée dans le procédé de la présente invention ;
- la figure 2 représente une vue en perspective et en coupe d'un exemple de moule utilisé dans le procédé de la présente invention ;
- les figures 3a à 3d représentent les étapes du procédé selon l'invention.

### EXPOSÉ DÉTAILLÉ D'UN MODE DE RÉALISATION PARTICULIER

Afin d'illustrer le procédé objet de l'invention, nous allons décrire la formation de piliers en diamant réalisés à partir de nanodiamants encapsulés dans un polymère nommé le pNIPAM.

Pour ce faire, on prépare une solution colloïdale de pNIPAM en utilisant une solution de N-isopropylacrylamide (ci-après « NIPAM ») concentrée à 97% comme monomère, une solution de N,N'-méthylène-bis-acrylamide (ci-après « BIS ») concentrée à plus de 99,5% comme agent de réticulation et une solution de potassium persulfate (ci-après « KPS ») concentrée à 99,99% comme amorceur ou initiateur de polymérisation. Ces solutions sont celles fournies par la société Sigma-Aldrich. L'eau ultra pure a une résistivité de 18,2 MΩ.cm (25°C).

Le mode opératoire suivi est celui décrit par Pelton et al. dans le document **[5].**

Dans un bécher équipé d'un barreau magnétique, on introduit 0,681 g de NIPAM à une concentration de 6.10⁻³ mol et 0,094 g de BIS à une concentration de 6.10⁻⁴ mol dans 60 ml d'eau ultra pure, préalablement dégazée et contenant une concentration de 17 µg/ml de nanoparticules.

Les nanoparticules utilisées sont des nanodiamants (ci-après « ND ») commercialisés par la société Van Moppes sous la référence Syndia^{®} SYP 0-0,2 ayant un diamètre moyen de 30 nanomètres.

Afin d'éliminer l'oxygène présent dans les solutions, le mélange des solutions et des nanoparticules est agité vigoureusement pendant 20 minutes en présence d'un flux d'azote. Puis, le mélange est chauffé jusqu'à atteindre une température de 70°C et on y ajoute 0,6 ml d'une solution de KPS à 0,1M (concentration de 6.10⁻⁵ mol) afin d'initier la polymérisation.

A l'apparition d'une faible opalescence, la vitesse d'agitation est abaissée pour éviter la floculation et on laisse la réaction de polymérisation se poursuivre pendant 3 h. Puis, des billes de microgel sont récupérées et lavées en effectuant plusieurs cycles de centrifugation-redispersion en utilisant de l'eau ultra pure.

On obtient des billes 1 comportant une nanoparticule de diamant 2 encapsulé dans une enveloppe en matériau d'enrobage 3 (ici pNIPAM) de forme sphérique ou quasi-sphérique.

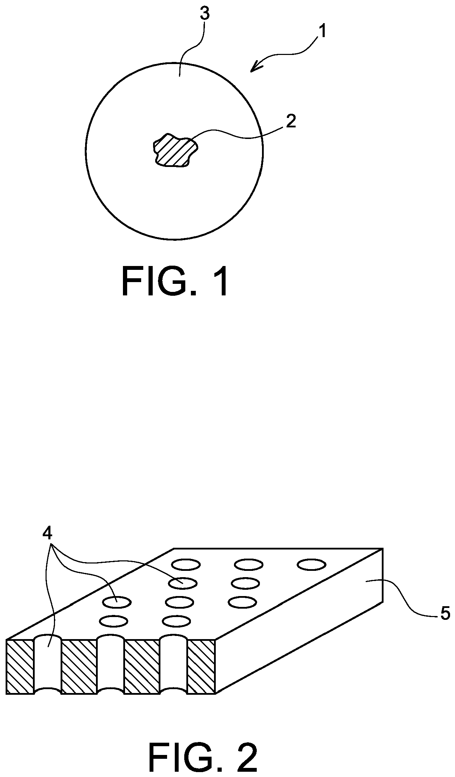

Ces billes 1 vont être placées dans les cavités 4 d'un moule 5 (figure 2).

Il est à noter que la taille des billes réalisées est ajustée en fonction de la taille des cavités du moule. Pour cela, on peut jouer sur la taille des nanoparticules de diamant et leur concentration dans le mélange réactif, ainsi que sur la température des billes une fois formées, comme le montre le tableau ci-dessous.

Les résultats présentés dans le tableau ci-dessous ont été obtenus en réalisant plusieurs synthèses différentes en utilisant le mode opératoire et les réactifs décrits ci-dessus, en changeant la concentration (17, 50 et 500 µg/ml) et le diamètre moyen des nanoparticules de diamant (30 nm et 100 nm). Pour l'échantillon 4, on a ainsi utilisé des nanodiamants commercialisés par la société Van Moppes sous la référence Syndia^{®} SYP 0-0,1 ayant un diamètre moyen de 100 nanomètres.

Le diamètre moyen des billes ainsi obtenues a ensuite été mesuré à 20°C et à 55°C pour mettre en évidence les propriétés thermosensibles du pNIPAM.

| | Diamètre ND (nm) | Concentration ND (µg/ml) | Diamètre des billes à 20°C (nm) | Diamètre des billes à 55°C (nm) |
|---|---|---|---|---|
| Billes de pNIPAM seul* | - | 0 | 525 | 315 |
| Echantillon 1 | 30 | 17 | 362 | 201 |
| Echantillon 2 | 30 | 50 | 259 | 154 |
| Echantillon 3 | 30 | 500 | 191 | 111 |
| Echantillon 4 | 100 | 50 | 467 | 257 |

| | | | | |
|---|---|---|---|---|
| *Billes de pNIPAM ne contenant pas de nanoparticules de diamant. | | | | |

On constate que les billes de pNIPAM ont un diamètre qui diminue lorsqu'on y introduit une nanoparticule de diamant.

D'autre part, on constate que le diamètre des billes de pNIPAM contenant une nanoparticule de diamant diminue lorsque la température des billes augmente et lorsque la concentration en nanoparticules augmente. En outre, lorsque le diamètre moyen des nanoparticules introduites dans le mélange réactif est augmenté de 30 à 100 nm, à concentration identique, le diamètre de la bille ainsi obtenue est aussi augmenté.

Ainsi, le choix du pNIPAM comme matériau d'enrobage des nanoparticules de diamant est judicieux dans le cadre de la présente invention, car l'addition des nanoparticules dans le milieu réactif (formé du monomère, de l'agent de réticulation et de l'amorceur) n'affecte pas la morphologie générale des billes de polymère (forme sphérique) et la taille des billes peut être modifiée de manière réversible en augmentant la température.

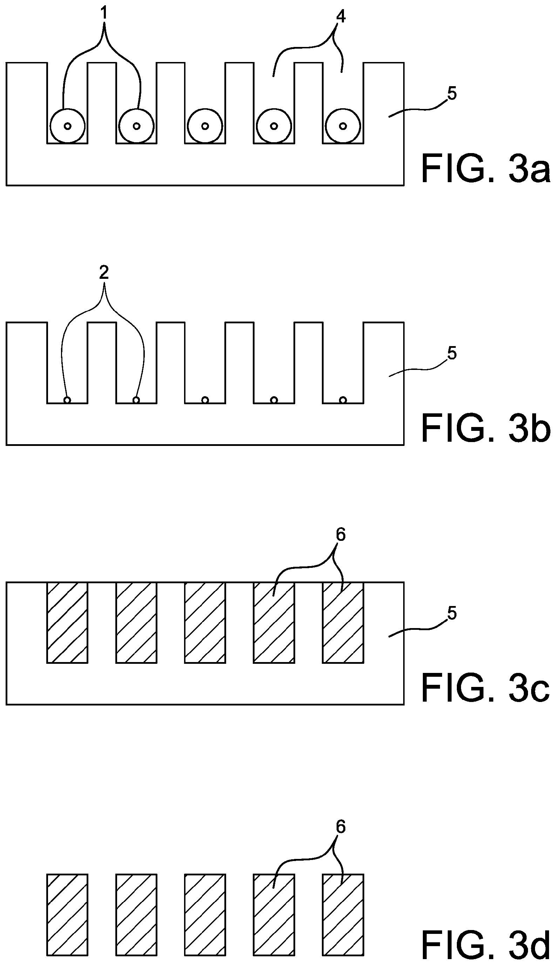

Une fois que les nanoparticules de diamant sont encapsulées dans le pNIPAM, elles peuvent être placées dans les cavités d'un moule (figure 3a).

Dans notre exemple de réalisation, le moule est en silicium. Il consiste en une plaque comportant des cavités, en l'occurrence des trous d'un diamètre de 600 nm et d'une profondeur de 1100 nm. De préférence, les trous présentent une ouverture plus large (629 nm) que leurs bases (575 nm).

Pour réaliser le dépôt des billes dans les cavités du moule, la technique la plus simple repose sur l'utilisation des forces de capillarité et d'un effet convectif, par exemple par dépôt à la tournette ou un trempage-retrait. Cette technique est bien connue de l'homme du métier et est décrite par Malaquin et al. (cf. document **[4]**).

Le dépôt des billes contenant les nanodiamants dans les cavités du moule peut ainsi être réalisé par extraction verticale du moule de la suspension colloïdale contenant les billes à vitesse constante et contrôlée (typiquement une vitesse inférieure à 10 µm/s).

Ainsi, en adaptant le diamètre des billes aux dimensions des cavités du moule - et, par voie de conséquence, aux dimensions des éléments à réaliser dans ces cavités - lorsqu'une bille rencontre une cavité, elle s'y dépose. De plus, compte-tenu du diamètre des billes, d'une part, et du diamètre et de la profondeur des trous, d'autre part, on limite le nombre de billes qu'il est possible d'introduire dans chaque trou, ce qui conduit à l'obtention d'un élément en diamant monocristallin ou faiblement cristallin.

Puis, une fois que les billes ont été déposées dans les cavités du moule, le moule ainsi rempli peut être transféré dans un réacteur de croissance CVD de diamant. Sous l'effet du plasma d'hydrogène et de méthane (mélange de H₂/CH₄ à 750°C), l'enveloppe polymérique des billes est brulée, libérant la particule de diamant au fond de la cavité du moule (figure 3b). La technique du dépôt chimique en phase vapeur (CVD) permet la croissance de la particule de diamant. En contrôlant finement les paramètres de croissance, des éléments 6 en un matériau d'excellente qualité cristalline sont obtenus, le matériau étant monocristallin ou très proche d'un matériau monocristallin, avec très peu de joints de grain (figure 3c).

Enfin, une fois que la croissance des éléments en diamant est terminée, on procède à l'élimination du moule sacrificiel 5 pour libérer les éléments 6 en diamant (figure 3d). Le moule étant en silicium, son élimination est obtenue en procédant à sa dissolution par voie chimique dans un mélange d'acide fluorhydrique et d'acide nitrique. De cette manière, on peut obtenir des nanopiliers en diamant monocristallin.

Dans le mode de réalisation que nous venons de décrire, un moule en silicium a été utilisé. Il est toutefois possible d'utiliser d'autres matériaux pour la réalisation du moule, à condition qu'ils puissent résister à l'exposition à un plasma CVD et qu'ils puissent être dissous chimiquement.

De même, dans le mode de réalisation ci-dessus, les nanoparticules de diamant ont été enrobées (ou encapsulées) dans une matrice polymérique en pNIPAM. D'autres types de polymères peuvent toutefois être envisagés.

### REFERENCES CITEES

**[1]** Bongrain et al. « Selective nucleation in silicon moulds for diamond MEMS fabrication », Journal of Micromechanics and Microengineering, n°7, volume 19, pages 1-7 (2009).
**[2]** Girard et al. « Electrostatic grafting of diamond nanoparticles towards 3D diamond nanostructures », Diamond and Related Materials, volume 23, pages 83-87 (2012).
[3] Babinec et al. « A diamond nanowire single-photon source », Nature Nanotechnology, volume 5, pages 195-199 (2010).
**[4]** Malaquin et al. « Controlled particle placement through convective and capillary assembly », Langmuir, volume 23, n°23, pages 11513-11521 (2007).
**[5]** Pelton et al. « Préparation of aqueous lattices with N-isopropylacrylamide », Colloids and Surfaces, volume 20, pages 247-256 (1986).

## Revendications

1. Procédé de fabrication d'éléments (6) moulés en diamant de tailles nanométriques, submicrométriques ou micrométriques, ledit procédé comprenant les étapes suivantes :
a) la formation de billes (1) de tailles nanométriques, submicrométriques ou micrométriques comprenant chacune une nanoparticule en diamant (2) enrobée par un matériau d'enrobage (3), par mise en contact de particules de diamant de tailles nanométriques avec un matériau d'enrobage ;
b) l'introduction d'une bille dans des cavités (4) d'un moule sacrificiel (5), les cavités formant une empreinte des éléments à fabriquer ;
c) l'élimination du matériau d'enrobage (3) ;
d) la formation des éléments (6) en diamant dans les cavités (4) contenant une nanoparticule (2), par croissance de diamant à partir des nanoparticules ;
e) libération des éléments (6) en diamant, par élimination partielle ou totale du moule sacrificiel (5).

2. Procédé selon la revendication 1, dans lequel l'étape a) comprend les opérations successives suivantes :
- la dispersion des nanoparticules dans un solvant ;
- le mélange de la suspension ainsi obtenue avec un ou plusieurs monomères, un ou plusieurs agents de réticulation du monomère et un ou plusieurs agents d'amorçage d'une réaction de réticulation du monomère, ce mélange étant réalisé sous agitation ; et
- la polymérisation et la réticulation du ou des monomères, pour obtenir la formation d'une couche de polymère réticulé autour des nanoparticules.

3. Procédé selon la revendication 1, dans lequel l'étape b) comprend le dépôt, par voie liquide, des billes dans les cavités du moule.

4. Procédé selon la revendication 3, dans lequel l'étape b) est réalisée par trempage-retrait ou par dépôt à la tournette.

5. Procédé selon la revendication 1, dans lequel l'étape c) est une dissolution chimique ou une destruction thermique.

6. Procédé selon la revendication 1, dans lequel la croissance de diamant à l'étape d) est réalisée par dépôt chimique en phase vapeur assisté par plasma.

7. Procédé selon la revendication 1 ou la revendication 6, dans lequel l'étape c) et l'étape d) sont réalisées successivement ou simultanément.

8. Procédé selon la revendication 1, dans lequel l'élimination à l'étape e) est une dissolution chimique.

9. Procédé selon la revendication 1, dans lequel les nanoparticules utilisées à l'étape a) sont en diamant monocristallin.

10. Procédé selon la revendication 1, dans lequel les billes ont un diamètre compris entre 0,6 et 0,8 fois la plus petite dimension des cavités.

11. Procédé selon la revendication 10, dans lequel les cavités ont une plus grande dimension et le rapport entre la dimension la plus petite et la dimension la plus grande est compris entre 0,3 et 1.

12. Procédé selon la revendication 1, dans lequel le matériau d'enrobage est choisi parmi les polymères dont le monomère est apte à s'adsorber sur une nanoparticule de diamant.

13. Procédé selon la revendication 12, dans lequel le matériau d'enrobage est le polymère pNIPAM.

14. Procédé selon la revendication 1, dans lequel le matériau du moule sacrificiel est choisi parmi un métal, un alliage métallique ou un oxyde.

15. Procédé de fabrication d'une structure en diamant comprenant, sur l'une de ses faces, une pluralité d'éléments de tailles nanométriques, submicrométriques ou micrométriques, ledit procédé comprenant la mise en oeuvre du procédé de fabrication d'éléments moulés en diamant de tailles nanométriques, submicrométrique ou micrométrique selon l'une quelconque des revendications 1 à 14, une étape étant ajoutée entre l'étape d) et l'étape e), cette étape consistant en une croissance catalytique de diamant par dépôt chimique en phase vapeur à partir des éléments obtenus à l'étape d), jusqu'à l'obtention d'une coalescence des éléments, formant ainsi la structure.

## Patentansprüche

1. Verfahren zum Herstellen von Formelementen (6) aus Diamant in nanometrischen, submikrometrischen bzw. mikrometrischen Größen, wobei das Verfahren die nachfolgenden Schritte umfasst:
a) Ausbilden von Kügelchen (1) in nanometrischen, submikrometrischen bzw. mikrometrischen Größen, die jeweils einen Nanopartikel aus Diamant (2) enthalten, der mit einem Hüllmaterial (3) umhüllt ist, und zwar durch Inkontaktbringen von Diamantpartikeln nanometrischer Größen mit einem Hüllmaterial;
b) Einführen eines Kügelchens in Hohlräume (4) einer Opfergießform (5), wobei die Hohlräume eine Prägung für die herzustellenden Elemente bilden;
c) Beseitigen des Hüllmaterials (3);
d) Ausbilden von Elementen (6) aus Diamant in den einen Nanopartikel (2) enthaltenden Hohlräumen (4) durch Diamantwachstum ausgehend von den Nanopartikeln;
e) Freigeben der Diamantelemente (6) durch teilweises oder vollständiges Beseitigen der Opfergießform (5).

2. Verfahren nach Anspruch 1, wobei der Schritt a) die nachstehenden, aufeinanderfolgenden Vorgänge umfasst:
- Dispergieren der Nanopartikel in einem Lösungsmittel;
- Vermischen der so gewonnenen Suspension mit einem oder mehreren Monomeren, einem oder mehreren Monomer-Vernetzungsmitteln und einem oder mehreren Auslösemitteln zum Auslösen einer Vernetzungsreaktion von Monomer, wobei dieses Vermischen unter Rühren erfolgt; und
- Polymerisieren und Vernetzen des bzw. der Monomere, um die Bildung einer Schicht aus vernetztem Polymer um die Nanopartikel herum zu erhalten.

3. Verfahren nach Anspruch 1, wobei der Schritt b) die strömungstechnische Ablagerung der Kügelchen in den Hohlräumen der Gießform umfasst.

4. Verfahren nach Anspruch 3, wobei der Schritt b) durch Tauchziehen oder durch Drehbeschichtung erfolgt.

5. Verfahren nach Anspruch 1, wobei der Schritt c) eine chemische Auflösung oder eine thermische Zerstörung ist.

6. Verfahren nach Anspruch 1, wobei das Diamantwachstum in Schritt d) durch plasmagestützte, chemische Dampfphasenabscheidung erfolgt.

7. Verfahren nach Anspruch 1 oder Anspruch 6, wobei Schritt c) und Schritt d) aufeinanderfolgend oder gleichzeitig durchgeführt werden.

8. Verfahren nach Anspruch 1, wobei die Beseitigung in Schritt e) eine chemische Auflösung ist.

9. Verfahren nach Anspruch 1, wobei die in Schritt a) verwendeten Nanopartikel aus monokristallinem Diamant bestehen.

10. Verfahren nach Anspruch 1, wobei die Kügelchen einen Durchmesser aufweisen, der das 0,6 bis 0,8-fache der kleinsten Abmessung der Hohlräume beträgt.

11. Verfahren nach Anspruch 10, wobei die Hohlräume eine größere Abmessung haben und das Verhältnis zwischen der kleinsten Abmessung und der größten Abmessung zwischen 0,3 und 1 liegt.

12. Verfahren nach Anspruch 1, wobei das Hüllmaterial ausgewählt ist aus Polymeren, deren Monomer an einem Diamant-Nanopartikel adsorbiert werden kann.

13. Verfahren nach Anspruch 12, wobei das Hüllmaterial das Polymer pNIPAM ist.

14. Verfahren nach Anspruch 1, wobei das Material der Opfergießform ausgewählt ist aus einem Metall, einer Metalllegierung oder einem Oxid.

15. Verfahren zum Herstellen einer Diamantstruktur, die an einer ihrer Flächen eine Mehrzahl von Elementen mit nanometrischen, submikrometrischen oder mikrometrischen Größen aufweist, wobei das Verfahren das Durchführen des Verfahrens zum Herstellen von Formelementen aus Diamant in nanometrischen, submikrometrischen bzw. mikrometrischen Größen nach einem der Ansprüche 1 bis 14 umfasst, wobei zwischen dem Schritt d) und dem Schritt e) ein Schritt hinzugefügt ist, wobei dieser Schritt aus einem katalytischen Diamantwachstum durch chemische Dampfphasenabscheidung ausgehend von Elementen besteht, die in Schritt d) gewonnen werden, bis eine Koaleszenz der Elemente erreicht wird, wodurch die Struktur gebildet wird.

## Claims

1. A process for producing moulded elements (6) made of diamond of nanometric, submicrometric or micrometric sizes, said process comprising the following steps:
a) forming beads (1) of nanometric, submicrometric or micrometric sizes, each bead comprising a diamond nanoparticle (2) embedded in an embedding material (3), by contacting diamond particles of nanometric sizes with an embedding material;
b) introducing a bead into cavities (4) of a sacrificial mould (5), the cavities forming a replica of the elements to be produced;
c) removing the embedding material (3);
d) forming diamond elements (6) in the cavities (4) containing a nanoparticle (2), by growing diamond from nanoparticles;
e) releasing the diamond elements (6), by partially or totally removing the sacrificial mould (5).

2. The process according to claim 1, wherein step a) comprises the following successive operations:
- dispersing the nanoparticles in a solvent;
- mixing the thus obtained suspension with one or more monomers, one or more cross-linking agents of the monomer and one or more initiators of a cross-linking reaction of the monomer, this mixing being made under stirring; and
- polymerizing and cross-linking the monomer(s), to obtain the formation of a cross-linked polymer layer around the nanoparticles.

3. The process according to claim 1, wherein step b) comprises wet depositing beads in the mould cavities.

4. The process according to claim 3, wherein step b) is carried out by dip coating or spin coating.

5. The process according to claim 1, wherein step c) is a chemical dissolution or a thermal destruction.

6. The process according to claim 1, wherein growing diamond in step d) is made by plasma-enhanced chemical vapour deposition.

7. The process according to claim 1 or claim 6, wherein step c) and step d) are made successively or simultaneously.

8. The process according to claim 1, wherein removing in step e) is a chemical dissolution.

9. The process according to claim 1, wherein the nanoparticles used in step a) are made of monocrystalline diamond.

10. The process according to claim 1, wherein beads have a diameter between 0.6 and 0.8 times the smallest dimension of the cavities.

11. The process according to claim 10, wherein the cavities have a largest dimension and the ratio of the smallest dimension to the largest dimension is between 0.3 and 1.

12. The process according to claim 1, wherein the embedding material is chosen from polymers the monomer of which is able to adsorb on a diamond nanoparticle.

13. The process according to claim 12, wherein the embedding material is the pNIPAM polymer.

14. The process according to claim 1, wherein the material of the sacrificial mould is chosen from a metal, a metallic alloy or an oxide.

15. A process for producing a diamond structure comprising, on one of its faces, a plurality of elements of nanometric, submicrometric or micrometric sizes, said process comprising implementing the process for producing moulded elements of diamond of nanometric, submicrometric or micrometric sizes according to any of claims 1 to 14, a step being added between step d) and step e), this step consisting in catalytically growing diamond by chemical vapour deposition from the elements obtained in step d), until a coalescence of elements is obtained, thus forming the structure.
